(19) **Europäisches Patentamt**

**European Patent Office**

**Office européen des brevets**

(11) Veröffentlichungsnummer: **0 150 347
B1**

(12) **EUROPÄISCHE PATENTSCHRIFT**

(51) Int. Cl.⁴: **H 01 L 25/04, H 01 L 23/48**

(45) Veröffentlichungstag der Patentschrift:
**30.03.88**

(21) Anmeldenummer: **84114843.0**

(22) Anmeldetag: **06.12.84**

(54) **Leistungs-Halbleiteranordnung.**

(30) Priorität: **14.12.83 DE 3345285**

(43) Veröffentlichungstag der Anmeldung:
**07.08.85 Patentblatt 85/32**

(45) Bekanntmachung des Hinweises auf die Patenterteilung:
**30.03.88 Patentblatt 88/13**

(84) Benannte Vertragsstaaten:
**BE DE FR GB IT SE**

(56) Entgegenhaltungen:
**EP - A - 0 064 856
DE - A - 2 617 335
DE - A - 2 942 409
DE - A - 3 143 339**

**PATENT ABSTRACTS OF JAPAN, Band 6, Nr. 72, 7. Mai
1982, Seite (E-105) (950); & JP-A-57-10952 (MITSUBISHI
DENKI K.K.) 20-01-1982
IBM TECHNICAL DISCLOSURE BULLETIN, Band 23, Nr.
12, Mai 1981, New York, USA; V.Y. DOO "Design of a
high-power dissipation module", Seite 5348**

(73) Patentinhaber: **Siemens Aktiengesellschaft Berlin und
München, Wittelsbacherplatz 2, D-8000 München 2 (DE)**

(72) Erfinder: **Wurz, Erwin, Ing. grad., Hoflacherstrasse 53,
D-8031 Eichenau (DE)**

## Beschreibung

Die Erfindung bezieht sich auf eine Leistungs-Halbleiteranordnung mit mindestens einem Halbleiterkörper, der mit einem gut wärmeleitenden, elektrisch isolierenden Substrat stoffschlüssig verbunden ist, mit einem Metallboden, auf dem das Substrat in thermischem Kontakt zum Boden angeordnet ist, mit einem mit dem Metallboden verbundenen Rahmen, mit mindestens zwei zur Führung eines Laststroms bestimmten Anschlussleitern, die den Halbleiterkörper elektrisch mit je einem von mindestens zwei in vorgegebener Lage auf der Oberseite des Rahmens angeordneten Anschlusskontakt verbinden, und mit einer Vergussmasse, die die Anschlussleiter und den Halbleiterkörper wenigstens teilweise einhüllt.

Eine Leistungs-Halbleiteranordnung dieser Art ist z.B. in der DE-OS 26 17 335 beschrieben worden. Bei solchen Anordnungen sind im allgemeinen die Gehäuseabmessungen, die Abstände der Anschlusskontakte zueinander und ihre Lage auf dem Gehäuse z.B. durch Normung festgelegt. Bei der beschriebenen Halbleiteranordnung sind die Anschlusskontakte durch bandähnliche Anschlussleiter mit den Halbleiterkörpern verbunden. Diese Anschlussleiter sind wegen der hohen Ströme massiv ausgebildet. Das bedeutet, dass auf die Anschlussleiter bzw. die Anschlusskontakte einwirkende Kräfte mindestens teilweise auf die Halbleiterkörper übertragen werden können. Dies hat man bisher durch eine harte Vergussmasse verhindert, die die Anschlussleiter fixiert. Eine solche Vergussmasse hat jedoch elektrisch oft unerwünschte Einwirkungen auf die Halbleiterkörper, so dass diese zusätzlich mit einer besonderen Passivierungsschicht versehen werden mussten. Die im wesentlichen starren Leiter erlauben darüber hinaus auch nur eine ganz bestimmte räumliche Lage der Halbleiterkörper im Gehäuse. Bei Abweichungen von dieser Lage und einer anderen Verschaltungsart der Halbleiterkörper im Gehäuse müssen diesem Verwendungszweck speziell angepasste Anschlussleiter verwendet werden.

Der Erfindung liegt die Aufgabe zugrunde, eine Leistungs-Halbleiteranordnung der beschriebenen Art so weiterzubilden, dass die Lage der Halbleiterkörper im Inneren des Gehäuses unabhängig von der Lage der Anschlusskontakte gewählt werden kann. Hierbei soll auf den Einsatz einer harten Vergussmasse verzichtet werden können.

Die Erfindung ist gekennzeichnet durch die Merkmale:

a) Jeder der Anschlussleiter besteht aus mindestens zwei Teilen,

b) der erste Teil ist am Rahmen befestigt und ist im wesentlichen starr ausgebildet,

c) der zweite Teil ist flexibel ausgebildet und einerseits elektrisch mit dem ersten Teil und andererseits mit dem Substrat oder dem Halbleiterkörper verbunden.

Weiterbildungen der Erfindung sind Gegenstand der Unteransprüche.

Die Erfindung wird an Hand einiger Ausführungsbeispiele in Verbindung mit den Fig. 1 bis 4 näher erläutert. Es zeigen:

Fig. 1 einen Längsschnitt durch eine Leistungs-Halbleiteranordnung mit drei verschiedenen Arten von Anschlusskontakten,

Fig. 2 eine Aufsicht auf die Anordnung nach Fig. 1,

Fig. 3 eine auf die Anordnung nach Fig. 1 und 2 aufsteckbare Kappe teilweise im Schnitt und teilweise in der Seitenansicht und

Fig. 4 die teilweise Aufsicht auf ein weiteres Ausführungsbeispiel der Erfindung.

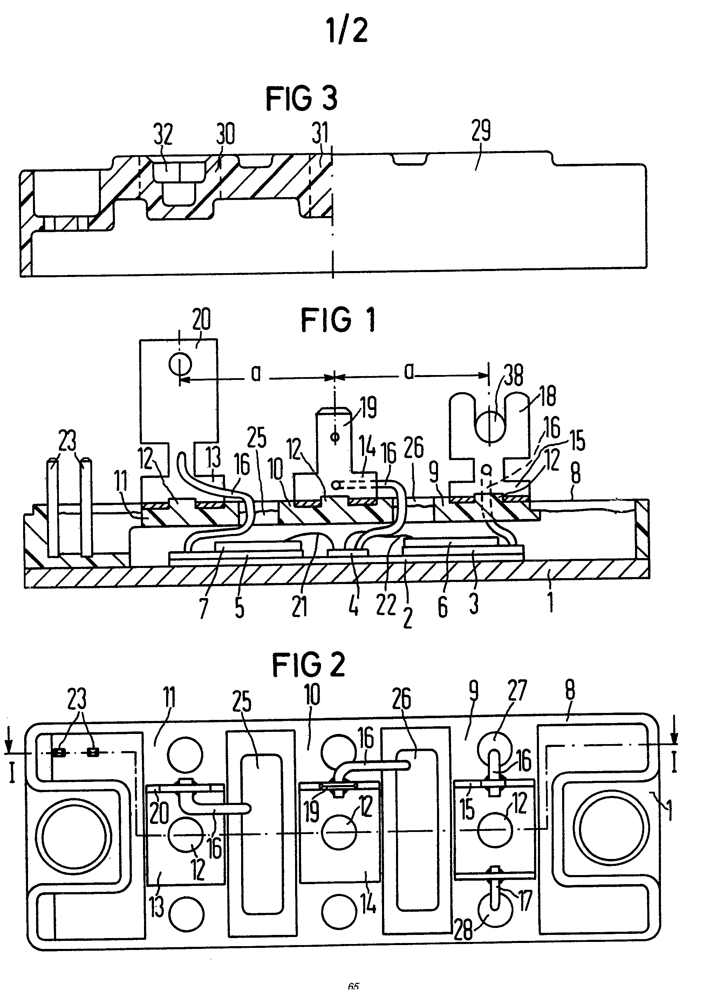

Die Leistungs-Halbleiteranordnung nach Fig. 1 hat als tragenden Bestandteil eine Metallplatte 1. Sie besteht beispielsweise aus vernickeltem Kupfer oder aus Aluminium, dessen Oberfläche mit einer lötfähigen Schicht versehen ist. Auf der Oberseite der Metallplatte 1 ist ein Substrat 2 angebracht, das elektrisch isolierend und thermisch gut leitend ist. Es besteht z.B. aus Berylliumoxid oder Aluminiumoxid. Auf dem Substrat sitzen zwei Halbleiterkörper 6, 7, die über je eine Metallisierungsschicht 3, 5 mit dem Substrat verlötet sind.

Auf der Bodenplatte 1 ist ein Isolierstoffrahmen 8 aufgesetzt und mit diesem beispielsweise verklebt. Der Rahmen ist mit Stegen 9, 10 und 11 versehen, die seine Längswände miteinander verbinden. Diese Stege können an der Oberkante des Rahmens, aber auch tiefer liegen. Auf den Stegen sind erste Anschlussleiterteile 13, 14, 15 befestigt. Die ersten Anschlussleiterteile bestehen z.B. aus Blech und sind im wesentlichen starr, vorzugsweise federnd, ausgebildet. Zur Befestigung dienen Kunststoffnoppen 12, die in ein waagrechtes Fussteil der genannten Anschlussleiterteile eingreifen. Die Noppen sind etwas höher als die Fussteile dick sind. Die Anschlussleiterteile können mit den Noppen z.B. durch Kleben verbunden werden. Besteht der Rahmen 8 aus einem Thermoplast, so werden die Noppen 12 erwärmt und verpresst. Die Anschlussleiterteile sind damit an den Stegen des Rahmens 8 fixiert.

In den Fig. 1 und 2 sind drei verschiedene Arten von Anschlusskontakten gezeigt, die Bestandteil der Anschlussleiterteile sind. Der linke Anschlusskontakt 20 ist für eine Schraubverbindung ausgebildet. Der mittlere Anschlusskontakt 19 ist ein Stecker, während der rechte Anschlusskontakt 18 mit einem Schlitz versehen ist, in die ein Draht 38 eingelegt und dort verlötet werden kann. In der Praxis wird eine solche Halbleiteranordnung nur eine Art der gezeigten Anschlusskontakte enthalten.

Die Anschlussleiterteile 13, 14 und 15 bilden jeweils den ersten Teil eines den Halbleiterkörper oder das Substrat mit den zugehörigen Anschlusskontakten verbindenden Anschlussleiters. Die zweiten Teile der Anschlussleiter bestehen aus flexiblen Litzen 16 oder Drähten. Sie sind einerseits in passende Öffnungen der Anschlussleiterteile 13, 14 und 15 eingesteckt und dort befestigt und andererseits mit den Halbleiterkörpern kontaktiert. Die Kontaktierung zwischen Halbleiterkörper und den flexiblen Litzen kann direkt, über die leitenden Zwischenlagen 3, 5 und/oder über einen aus einer Metallschicht bestehenden Stützpunkt 4 erfolgen, der mit dem Substrat 2 beispielsweise verlötet ist. Der Stützpunkt 4 und die Halbleiterkörper, aber auch die Halbleiterkörper selbst können elektrisch durch Bonddrähte verbunden werden, von denen hier zwei dargestellt und mit 21, 22 bezeichnet sind.

Die flexiblen Drähte oder Litzen 16 werden durch zwischen den Stegen liegende Öffnungen 25, 26 oder auch durch in den Stegen angebrachte Öffnungen geführt, von denen in Fig. 2 auf jedem Steg zwei dargestellt und auf dem Steg 9 mit 27, 28 bezeichnet sind. Wo die flexiblen Teile der Anschlussleiter aus dem Rahmen treten, hängt von der Lage der Halbleiterkörper im Rahmen ab. Diese Lage kann wegen der Flexibilität der Anschlussleiter 16 auf der zur Verfügung stehenden Fläche des Metallbodens 1 frei gewählt werden. So können in einer solchen Leistungs-Halbleiteranordnung insbesondere komplexe Schaltungen aus mehreren Halbleiterkörpern mit unter Umständen verschiedenen Funktionen vereinigt werden. Ein weiterer Vorteil besteht darin, dass zwischen den Halbleiterkörpern eine Bondverbindung möglich ist, ohne dass starre Anschlussleiter beim Bonden im Wege sind. Die flexiblen Leiter 16 werden dann zweckmässigerweise nach dem Bonden angebracht.

Zum Einbau in Leiterplattensysteme empfiehlt es sich, die Mittenabstände a der Anschlussleiter bzw. Anschlusskontakte gleich gross und im Rastermass oder in einem Vielfachen davon auszubilden. Zum Schutz der Halbleiterkörper wird der Rahmen mit einer Vergussmasse gefüllt. Diese kann weich oder gallertartig, z.B. ein Silikongel, sein, da sie keine Fixierung für die Anschlussleiter übernehmen muss. Die auf die Anschlussleiter ausgeübten Kräfte beim Kontaktieren und im Betrieb werden ausschliesslich durch die Stege und damit durch den Rahmen aufgenommen.

Auf den Rahmen 8 kann eine in Fig. 3 gezeigte Isolierstoffkappe 29 aufgesetzt werden. Diese weist schlitzartige Öffnungen 30, 31 auf, durch die die Anschlusskontakte 20, 19 hindurchpassen. Die Öffnung für den Anschlusskontakt wurde nicht dargestellt. Wird als Anschlusskontakt die Form des Anschlusskontaktes 20 verwendet, so kann an der Oberseite der Kappe 29 neben dem Schlitz 30 eine Metallmutter 32 eingegossen sein, an die eine Anschlussleitung angeschraubt werden kann.

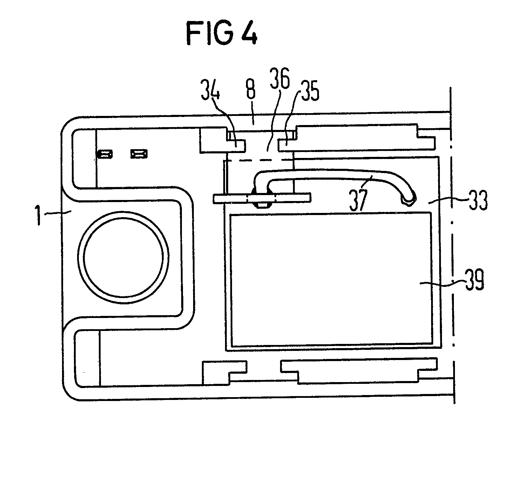

In Fig. 4 ist eine weitere Ausführungsform mit einer anderen Art der Fixierung des Anschlussleiters am Rahmen gezeigt. Eine Seitenwand des Rahmens 8 ist mit Führungsschienen 34, 35 versehen, in die eine Lasche eines Z-förmigen bandförmigen Leiters 36 eingeführt wird. Der Leiter 36 bildet den ersten Teil des Anschlussleiters. Der zweite Teil des Anschlussleiters ist wieder durch einen flexiblen Draht oder eine Litze 37 gebildet, die in einer Öffnung des ersten Leiters 36 sitzt und dort verlötet ist. Am anderen Ende ist die Litze 37 mit einem Substrat 33 verbunden, auf dem ein Halbleiterkörper 39 sitzt. Die Teile 36 und 37 können hierbei miteinander oberhalb oder unterhalb einer in den Rahmen 8 eingefüllten Vergussmasse verbunden sein.

Reicht eine Litze zur Führung des Stromes nicht aus, so können mehrere parallele Litzen verwendet werden, wie beim Anschlussleiter 15 gezeigt. Die zusätzliche Litze ist in Fig. 2 mit 17 bezeichnet.

## Patentansprüche

1. Leistungs-Halbleiteranordnung mit mindestens einem Halbleiterkörper, der mit einem gut wärmeleitenden, elektrisch isolierenden Substrat stoffschlüssig verbunden ist, mit einem Metallboden, auf dem das Substrat in thermischem Kontakt zum Boden angeordnet ist, mit einem dem Metallboden verbundenen Rahmen, mit mindestens zwei zur Führung eines Laststroms bestimmten Anschlussleitern, die den Halbleiterkörper elektrisch mit je einem von mindestens zwei in vorgegebener Lage auf der Oberseite des Rahmens angeordneten Anschlusskontakt verbinden, und mit einer Vergussmasse, die die Anschlussleiter und den Halbleiterkörper wenigstens teilweise einhüllt, gekennzeichnet durch die Merkmale:

a) Jeder der Anschlussleiter besteht aus mindestens zwei Teilen (13, 14, 15; 16)

b) der erste Teil (13, 14, 15) ist am Rahmen (8) befestigt und ist im wesentlichen starr ausgebildet,

c) der zweite Teil (16) ist flexibel ausgebildet und einerseits elektrisch mit dem ersten Teil und andererseits mit dem Substrat (3, 5) oder dem Halbleiterkörper (6, 7) verbunden.

2. Leistungs-Halbleiteranordnung nach Anspruch 1 dadurch gekennzeichnet, dass der Rahmen (8) rechteckig ist und dass er mit mindestens einem seiner Längsseiten verbindenden Steg (9, 10) 11) versehen ist.

3. Leistungs-Halbleiteranordnung nach Anspruch 2, dadurch gekennzeichnet, dass der Steg auf der Höhe der Oberkante des Rahmens (8) sitzt.

4. Leistungs-Halbleiteranordnung nach Anspruch 2 oder 3, dadurch gekennzeichnet, dass der Steg einen Befestigungspunkt (12) für den ersten Teil des Anschlussleiters (13, 14, 15) aufweist, dass der zweite Teil des Anschlussleiters (16) bis zum Steg (9, 10, 11) reicht und ausserhalb der Vergussmasse mit dem ersten Teil des Anschlussleiters verbunden ist.

5. Leistungs-Halbleiteranordnung nach einem der Ansprüche 1 bis 4, dadurch gekennzeichnet, dass der erste Teil des Anschlussleiters mit einem Anschlusskontakt (18, 19, 20) verbunden ist.

6. Leistungs-Halbleiteranordnung nach Anspruch 5, dadurch gekennzeichnet, dass der Anschlusskontakt und der erste Teil des Anschlussleiters ein einziges Stück bilden.

7. Leistungs-Halbleiteranordnung nach Anspruch 1, dadurch gekennzeichnet, dass der Rahmen (8) mit einer mit Öffnungen (30, 31) für die Anschlusskontakte (2 19, 18) versehenen Kappe (29) abgedeckt ist.

8. Leistungs-Halbleiteranordnung nach Anspruch 7, dadurch gekennzeichnet, dass die Kappe (29) an ihrer Oberseite mit Anschlussklemmen (32) versehen ist, die elektrisch mit den Anschlusskontakten verbunden sind.

9. Leistungs-Halbleiteranordnung nach Anspruch 1, dadurch gekennzeichnet, dass der Rahmen (8) mit einer elastischen Vergussmasse gefüllt ist.

10. Leistungs-Halbleiteranordnung nach Anspruch 1, dadurch gekennzeichnet, dass die Anschlusskontakte einen Mittenabstand (a) voneinander haben, der einem Rastermass oder einem Vielfachen dieses Rastermasses entspricht.

11. Leistungs-Halbleiteranordnung nach Anspruch 1, dadurch gekennzeichnet, dass der erste Teil (13, 14, 15) der Anschlussleiter über mehrere Litzen (16, 17) oder flexible Drähte mit dem Substrat und/oder dem Halbleiterkörper verbunden ist.

## Revendications

1. Dispositif semi-conducteur de puissance comprenant au moins un corps semi-conducteur qui est réuni par une liaison des matières à un substrat bon conducteur thermique et électriquement isolant, un fond métallique sur lequel le substrat est disposé en contact thermique avec ce fond, un cadre relié au fond métallique, au moins deux conducteurs de raccordement destinés à la conduction d'un courant de charge, qui relient chacun le corps semi-conducteur électriquement à l'un d'au moins deux contacts de raccordement disposés à des positions prédéterminées sur le dessus du cadre, ainsi qu'une masse de scellement qui enveloppe les conducteurs de raccordement et les corps semi-conducteurs en partie au moins, caractérisé en ce que:

a) chacun des conducteurs de raccordement est formé d'au moins deux parties (13, 14, 15; 16),

b) dont la première partie (13, 14, 15) est fixée au cadre (8) et est essentiellement rigide et

c) dont la seconde partie (16) est flexible et est reliée électriquement, d'une part à la première partie et d'autre part au substrat (3, 5) ou au corps semi-conducteur (6, 7).

2. Dispositif selon la revendication 1, caractérisé en ce que le cadre (8) est rectangulaire et qu'il est pourvu d'au moins une entretoise (9, 10, 11) reliant se côtés longitudinaux.

3. Dispositif selon la revendication 2, caractérisé en ce que l'entretoise est située à la hauteur du bord supérieur du cadre (8).

4. Dispositif selon la revendication 2 ou 3, caractérisé en ce que l'entretoise présente un point de fixation (12) pour la première partie du conducteur de raccordement (13, 14, 15) et que la seconde partie du conducteur de raccordement (16) s'étend jusqu'à l'entretoise (9, 10, 11) et est reliée, en dehors de la masse de scellement, à la première partie du conducteur de raccordement.

5. Dispositif selon une des revendications 1 à 4, caractérisé en ce que la première partie du conducteur de raccordement est reliée à un contact de raccordement (18, 19, 20).

6. Dispositif selon la revendication 5, caractérisé en ce que le contact de raccordement et la première partie du conducteur de raccordement sont constitués par un seul élément.

7. Dispositif selon la revendication 1, caractérisé en ce que le cadre (8) est recouvert par un capot (29) pourvu d'ouvertures (30, 31) pour le passage des contacts de raccordement (20, 19, 18).

8. Dispositif selon la revendication 7, caractérisé en ce que le dessus du capot (29) est pourvu de bornes de raccordement (32) qui sont connectés électriquement aux contacts de raccordement.

9. Dispositif selon la revendication 1, caractérisé en ce que le cadre (8 est rempli par une masse de scellement élastique.

10. Dispositif selon la revendication 1, caractérisé en ce que les contacts de raccordement présentent un entraxe (a) qui correspond à une dimension modulaire ou à un multiple de cette dimension.

11. Dispositif selon la revendication 1, caractérisé en ce que la première partie (13, 14, 15) des conducteurs de raccordement est reliée par plusieurs torons (16, 17) ou par plusieurs fils flexibles au substrat et/ou au corps semi-conducteur.

## Claims

1. A power semiconductor arrangement comprising at least one semiconductor component which is materially connected to a good heat-conducting, electrically insulating substrate; a metal base on which the substrate is arranged in thermal contact with the base; a frame connected to the metal base; at least two connecting conductors which serve to conduct a load current and which electrically connect the semiconductor component in each case to one of at least two terminal contacts which are arranged in a predetermined position on the upper side of the frame; and a cast mass in which the connecting conductors and the semiconductor component are at least partially embedded, characterised by the following features:

a) each of the connecting conductors consists of at least two parts (13, 14, 15; 16),

b) the first part (13, 14, 15) is secured to the frame (8) and is essentially rigid,

c) the second part (16) is flexible and is, on the one hand, electrically connected to the first part and, on the other hand, to the substrate (3, 5), or the semiconductor component (6, 7).

2. A power semiconductor arrangement as claimed in Claim 1, characterised in that the frame 8) is rectangular and is provided with at least one cross-piece (9, 10, 11) connecting its long sides.

3. A power semiconductor arrangement as claimed in Claim 2, characterised in that the cross-piece is located at the level of the upper edge of the frame (8).

4. A power semiconductor arrangement as claimed in Claim 2 or 3, characterised in that the cross-piece has a point of attachment, (12), for the first part of the connecting conductor (13, 14, 15), and that the second part of the connecting conductor (16) extends to the cross-piece (9, 10, 11) and outside the cast mass, is connected to the first part of the connecting conductor.

5. A power semiconductor arrangement as claimed in one of Claims 1 to 4, characterised in that the first part of the connecting conductor is connected to a terminal contact (18, 19, 20).

6. A power semiconductor arrangement as claimed in Claim 5, characterised in that the terminal contact and the first part or the connecting conductor form a single element.

7. A power semiconductor arrangement as claimed in Claim 1, characterised in that the frame (8) is covered by a cap (29) which is provided with openings (30, 31) for the terminal contacts (20, 19, 18).

8. A power semiconductor arrangement as claimed in Claim 7, characterised in that the cap (29) is provided on its upper side with connection terminals (32) which are electrically connected to the terminal contacts.

9. A power semiconductor arrangement as claimed in Claim 1, characterised in that the frame (8) is filled with an elastic cast mass.

10. A power semiconductor arrangement as claimed in Claim 1, characterised in that the mean spacing (a) between the terminal contacts corresponds to the grid dimensioning or to a multiple thereof.

11. A power semiconductor arrangement as claimed in Claim 1, characterised in that the first part (13, 14, 15) of the connecting conductors is connected through a plurality of litz wires (16, 17), or flexible wires, to the substrate and/or the semiconductor component.

FIG 3

FIG 1

FIG 2

FIG 4